# FASCICULE DE BREVET EUROPEEN

(11) **EP 2 166 547 B1**
(45) Date de publication et mention de la délivrance du brevet: **11.10.2017**
(21) Numéro de dépôt: 09170803.2
(22) Date de dépôt: 21.09.2009
(51) Int. Cl.: H01G 4/12, C23C 14/08, C23C 14/56, C23C 14/58

(54) **Procédé de préparation d'un matériau oxyde céramique a structure pyrochlore présentant une constante diélectrique élevée et mise en oeuvre de ce procédé pour des applications de microélectronique**
Herstellungsverfahren einer Keramik mit Pyrochlorphase und Oxiden, die eine hohe dieletrische Konstante aufweist und deren Verwendung in der Mikroelektronik
Process for preparation for ceramic oxide material with pyrochlore structure having a high dielectric strength and method for use this process in microelectronics application

(30) Priorité: 23.09.2008 FR 0856386
(43) Date de publication de la demande: 24.03.2010
(73) Titulaire: Commissariat à l'Énergie Atomique et aux Énergies Alternatives, 75015 Paris (FR)
(72) Inventeur: Zhu, Xiaohong, 610064 Chengdu P.R. (CN); Defay, Emmanuel, 38340 Voreppe (FR); Fribourg-Blanc, Eric, 91800 Brunoy (FR)
(74) Mandataire: Ilgart, Jean-Christophe

(56) Documents cités:
- US-A- 4 203 871
- US-A- 4 637 989
- US-A1- 2003 136 998
- US-A1- 2003 161 959
- US-A1- 2003 184 952
- US-A1- 2005 098 816
- US-B1- 6 432 725

## Description

### DOMAINE TECHNIQUE

La présente invention a trait à un procédé de préparation d'un matériau oxyde céramique à base de plomb à structure pyrochlore, ce matériau présentant, avantageusement, une perte diélectrique ≤0,015 et une constante diélectrique ≥40.

Ce procédé trouve, en particulier, son application dans la réalisation de composants passifs, notamment dans la conception de condensateurs, comprenant une partie diélectrique capable de stocker une quantité importante de charge électrique par unité de surface, ces composés pouvant être destinés à être disposés à la surface de circuits intégrés (correspondant ainsi à l'approche « above IC » signifiant littéralement « au-dessus des circuits intégrés »). Ce procédé trouve également une application dans la réalisation de composants de type « STAND ALONE » (correspondant à des composants réalisés sur un substrat indépendant de celui des circuits intégrés auxquels ils sont associés).

### ÉTAT DE LA TECHNIQUE ANTÉRIEURE

En matière de microélectronique, il existe un besoin actuel de miniaturiser les dispositifs électroniques et notamment les parties diélectriques de ceux-ci, tout en préservant leurs propriétés électriques.

Les propriétés électriques d'un matériau diélectrique peuvent être exprimées par les grandeurs suivantes :
- la constante diélectrique relative du matériau diélectrique (représentée classiquement par εᵣ), qui exprime en quelque sorte le caractère isolant du matériau ;
- le facteur de dissipation électrique (représenté classiquement par tanδ), qui exprime, pour un matériau isolant soumis à une tension sinusoïdale, le rapport de la puissance active absorbée à la valeur absolue de la puissance réactive ;
- le facteur de qualité diélectrique, correspondant à l'inverse du facteur de dissipation électrique.

Pour des dispositifs capacitifs destinés à être inclus dans des circuits intégrés, la constante diélectrique doit être, idéalement, une constante diélectrique élevée (par exemple, au moins égale à 40), un facteur de dissipation faible (par exemple, inférieur à 2%), ces propriétés devant découler de la nature des matériaux diélectriques utilisés.

Le matériau diélectrique le plus communément utilisé, à l'heure actuelle, dans les circuits intégrés, est le dioxyde de silicium, SiO₂. Ce matériau diélectrique présente toutefois un certain nombre d'inconvénients, parmi lesquels on peut citer une faible constante diélectrique de l'ordre de 3,9. Pour obtenir des valeurs de capacité nécessaires au bon fonctionnement des circuits, les capacités utilisant le dioxyde de silicium en tant que matériau diélectrique doivent, pour compenser la valeur de constante diélectrique relativement faible, présenter une surface très élevée et voire une épaisseur très faible, ce qui est incompatible avec la volonté d'obtenir une densité importante de composés capacitifs dans les circuits intégrés. Qui plus est, en diminuant l'épaisseur des couches de SiO₂, il peut apparaître des courants de tunnel élevés préjudiciables au bon fonctionnement des circuits intégrés, dans lesquels les capacités sont incluses. Il importe donc de développer des matériaux diélectriques présentant une constante diélectrique plus élevée que celle du dioxyde de silicium SiO₂.

Ainsi, certains auteurs ont mis en place d'autres matériaux diélectriques tels que des matériaux céramiques oxydes cristallisés selon le système pérovskite tels que des matériaux en zircono-titanate de plomb (connus sous l'abréviation PZT).

Ces matériaux comportent, avantageusement, une constante diélectrique très élevée (de l'ordre de 1000) mais toutefois une perte diélectrique également élevée (de l'ordre de 0,02-0,05), ce qui peut s'avérer gênant dans certaines applications de microélectronique.

Plus spécifiquement, il est décrit :
- dans US 2003/136998, un procédé de fabrication d'une capacité mettant en oeuvre un film à haute constante diélectrique de structure pérovskite en titanate de baryum et de strontium, ledit film étant déposé par pulvérisation cathodique magnétron à une température de 500°C ;
- dans US 6 432 725, un procédé de préparation d'une couche pérovskite cristallisée, telle que du BSTO (oxyde de titane, de strontium et de baryum) à basses températures ;
- dans US 4 637 989, un procédé de préparation d'une solution solide de niobate de plomb contenant du zinc et du magnésium de structure pérovskite comprenant une étape de formation d'une phase columbite de niobate de zinc et de magnésium suivie d'une étape de calcination de la phase columbite avec de l'oxyde de plomb pour former un niobate de plomb, de zinc et de magnésium, la température de calcination étant d'au moins 900°C ; et
- dans US 2005/098816, un procédé de fabrication d'une capacité mettant en oeuvre un film diélectrique de structure pérovskite en titanate de baryum et de strontium, ledit film étant formé par procédé sol-gel, pulvérisation cathodique magnétron ou MOCVD.

Certains auteurs ont également élaboré des matériaux céramiques oxydes cristallisés selon un système pyrochlore, tels que des matériaux de compositions suivantes : (Bi₃ₓZn₂₋₃ₓ) (ZnₓNb₂₋ₓ)O₇ (tels que décrit dans US 6,482,527) et (BaₓSr₁₋ₓ)₂(Ta_{y}Nb_{1-y})₂O₇ (tels que décrit dans US 6,495,878).

En particulier, il est décrit dans US 2003/184952, un procédé de fabrication d'une capacité à film(s) mince(s) dont un des films est un film diélectrique polycristallin, qui peut être un matériau de structure pyrochlore, tel que Pb₂(ZrTi)₂O₇. La préparation des films minces passe par :
- une étape de croissance d'une couche amorphe sur un substrat porté à une température inférieure à 450°C ;
- une étape de croissance d'une couche cristallisée sur la couche amorphe, le dépôt de la couche cristallisée se faisant spontanément en raison de l'élévation de température de la surface de croissance générée par des phénomènes de collision, cette élévation de température entraînant la formation spontanée de grains cristallins.

Dans US 2003/161959, il est décrit la fabrication de matériaux à structure pyrochlore, tel que Pb₂Ta₂O7.

La préparation de ce matériau est notamment explicitée à l'exemple 3 par mélange d'éthoxyde de tantale, d'éthylhexanoate de plomb, suivie d'un chauffage à 450°C pour obtenir une décomposition des précurseurs. La formation de Pb₂Ta₂O₇ intervient à partir d'une température de 550°C appliquée pendant 1 heure.

Toutefois, la préparation de tels matériaux nécessite de travailler à des températures souvent supérieures ou égales à 550°C. De telles températures peuvent être néfastes, notamment lorsque les matériaux sont destinés à être réalisés sur des circuits intégrés, de tels niveaux de température pouvant engendrer une dégradation des composants environnants et des interconnexions.

Enfin, US 6 975 501 décrit, de manière générique, la fabrication de matériaux de type pérovskites ABO₃ ou pyrochlores A₂B₂O₇ mettant en oeuvre des températures de recuit pouvant s'échelonner de 100 à 900°C et US 4 203 871 décrit la préparation de composés pyrochlores de formule A₂[B₂₋ₓAₓ]O_{7-y} avec A étant du plomb, du bismuth ou des mélanges de ceux-ci et B étant du ruthénium, de l'iridium et des mélanges de ceux-ci mettant en oeuvre une gamme de températures de cristallisation allant de 100 à 600°C.

Il existe donc un véritable besoin pour un procédé de préparation de matériaux céramiques oxydes, ces matériaux céramiques oxydes pouvant officier en tant que matériaux diélectriques dans des composants électroniques tels que des condensateurs incorporés dans des circuits intégrés, ce procédé ne devant pas nécessiter de recourir à des températures susceptibles de dégrader des composants environnants et qui plus est devant permettre l'obtention de matériaux diélectriques présentant, à tout le moins, une constante diélectrique élevée et un facteur de dissipation diélectrique faible.

### EXPOSÉ DE L'INVENTION

Ainsi, les présents inventeurs ont découvert, de façon surprenante, qu'en travaillant dans une certaine gamme de températures de recuit, à partir d'un matériau de base particulier, il était possible d'obtenir des matériaux cristallisant selon le système pyrochlore et présentant des propriétés diélectriques particulièrement intéressantes, telles qu'une constante diélectrique élevée et un facteur de dissipation thermique faible.

Ainsi, l'invention a trait à un procédé de préparation d'un matériau diélectrique céramique oxyde à base de plomb comprenant au moins une phase cristalline pyrochlore choisi parmi le niobate de plomb, le magnoniobate de plomb et une solution solide résultant d'un mélange de magnoniobate de plomb et de titanate de plomb comprenant les étapes suivantes :
a) une étape de dépôt sur un substrat d'au moins une couche amorphe dudit matériau céramique oxyde à base de plomb;
b) une étape de recuit de cristallisation de ladite couche amorphe à une température inférieure ou égale à 550°C, moyennant quoi l'on obtient un matériau diélectrique céramique oxyde à base de plomb comprenant au moins une phase pyrochlore choisi parmi le niobate de plomb, le magnoniobate de plomb et une solution solide résultant d'un mélange de magnoniobate de plomb et de titanate de plomb.

Avantageusement, l'étape de recuit de cristallisation de ladite couche amorphe est réalisée à une température inférieure ou égale à 450°C, de préférence de 400 à 450°C.

Les étapes a) et b) susmentionnées peuvent être réalisées successivement ou simultanément.

Ainsi, les inventeurs ont découvert, de manière surprenante, qu'en appliquant une étape de recuit de cristallisation à une température inférieure ou égale à 550°C à un matériau céramique oxyde amorphe à base de plomb, il était possible d'obtenir une cristallisation en tout ou partie de celui-ci selon un système pyrochlore et qui plus est, d'obtenir des propriétés diélectriques de ce matériau particulièrement avantageuses, à savoir une constante diélectrique élevée, avantageusement supérieure à 40 et un facteur de dissipation diélectrique faible, avantageusement inférieure à 0,015 et une rigidité diélectrique avantageusement supérieure ou égale à 800 kV/cm.

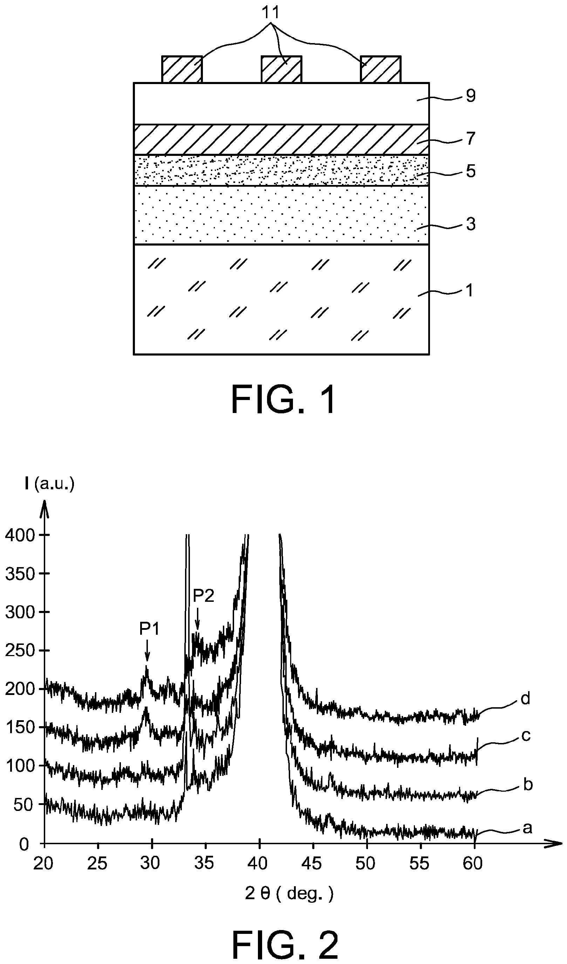

On précise que, par système pyrochlore, on entend généralement une structure cristalline du type A₂B₂O₆ et A₂B₂O₇ avec A étant du plomb, B pouvant être Nb, Mg, Ti et des mélanges de ceux-ci, ce système se caractérisant notamment par la présence sur des diagrammes de diffraction aux rayons X de pics P1 et P2 conformément à ce qui est présenté, pour un cas particulier, sur la figure 2.

Des matériaux en céramique oxyde comprenant au moins une phase cristalline pyrochlore réalisés conformément au procédé de l'invention sont des couches de niobate de plomb (pouvant être intitulées couches « PN »), des couches de magnoniobate de plomb (pouvant être intitulées couches « PMN »), et des couches d'une solution solide résultant d'un mélange de magnoniobate de plomb et de titanate de plomb (pouvant être intitulées couches « PMNT »). En particulier, la couche en céramique oxyde à structure pyrochlore préparée par le procédé de l'invention peut être une couche PMNT répondant à la composition nominale suivante :

(1-x)Pb(Mg_{1/3}Nb_{2/3})O₃-xPbTiO₃

x allant de 0 à 1, 1 n'étant pas inclus, en particulier, x pouvant être égal à 0,1.

L'étape de dépôt de la couche en matériau céramique oxyde amorphe a) sur le substrat susmentionné peut être réalisée par une technique choisie parmi :
- les techniques de dépôt physique en phase vapeur (connues sous l'abréviation PVD) ;
- les techniques de dépôt chimique en phase vapeur (connues sous l'abréviation CVD) ;
- les techniques de dépôt par voie solution.

Les techniques de dépôt physique en phase vapeur peuvent se subdiviser en deux sous groupes :
- les techniques PVD de dépôt par évaporation sous vide ;
- les techniques PVD de dépôt par pulvérisation cathodique.

Les techniques de dépôt par évaporation sous vide consistent à chauffer sous vide le matériau que l'on veut déposer. Les atomes du matériau à évaporer reçoivent une énergie calorifique suffisante pour dépasser l'énergie de liaison de ces atomes et engendrer l'évaporation. Les atomes du matériau à l'état de vapeur se condensent ensuite sur le substrat à recouvrir. Différents modes de chauffage du matériau peuvent être envisagés parmi lesquels on peut citer le chauffage par bombardement d'électrons, le chauffage par effet joule, par arc électrique, par induction, par faisceau d'ions, par ablation laser (la technique étant alors dans ce dernier cas connue sous l'abréviation PLD).

Les techniques de dépôt par pulvérisation cathodique consistent à éjecter des particules de la surface du matériau à déposer (dite cible) par le bombardement de cette surface avec des particules énergétiques (la vapeur étant ainsi créée par effet mécanique), telles que des ions argon, les particules pouvant provenir soit d'un plasma, soit d'une source d'ions. On peut citer, en particulier, la pulvérisation assistée par faisceau d'ions (connue sous l'abréviation IBS pour « Ion Beam Sputtering »).

Avantageusement, l'étape de dépôt de l'invention peut être réalisée par une technique particulière de dépôt par pulvérisation cathodique : la pulvérisation cathodique magnétron.

La pulvérisation cathodique magnétron consiste, classiquement, à équiper la cible d'un dispositif magnétron constitué de deux aimants concentriques de polarités inverses. Une pièce polaire ferme le circuit magnétique d'un côté, tandis que la cible, amagnétique pour autoriser l'effet magnétron, laisse les lignes de champ se refermer au sein de la phase gazeuse, ce qui a pour effet de piéger les électrons secondaires et ainsi d'accroître leur possibilité de rencontrer un atome de gaz plasmagène (tel que l'argon) dans le cadre d'une interaction ionisante. Un plasma dense est alors généré au droit de l'entrefer des aimants, ce plasma conduisant au contact de la cible à une érosion de cette dernière et ainsi à une transformation du matériau de la cible en particules qui vont pouvoir se déposer sur le substrat.

Avantageusement, lors de la mise en oeuvre de cette technique, le substrat n'est pas soumis à une étape de chauffage, hormis le chauffage découlant du bombardement ionique issu de la pulvérisation magnétron.

A titre d'exemple, pour ce type de technique, la cible peut être une composition céramique de composition nominale 0,9Pb(Mgl_{1/3}Nb_{2/3})O₃-0,1PbTiO₃ et le gaz plasmagène utilisé peut être de l'argon.

Les techniques de dépôt chimique en phase vapeur (connues sous l'abréviation CVD) consistent à déposer sur la surface du substrat un matériau qui passe de l'état gazeux à l'état solide, lorsque se produit une réaction chimique entre les composants mis en présence. Les composés réagissant entre eux pour fournir la céramique oxyde à déposer peuvent être des chlorures métalliques, des composés organométalliques en présence de gaz, tels que l'hydrogène et le dioxyde de carbone.

Dans le cas où la technique fait intervenir des composés organométalliques, elle est classiquement intitulée MOCVD (correspondant à la terminologie anglo-saxonne « Métal Organic Chemical Vapor Déposition »).

Enfin, les techniques de dépôt par voie solution comprennent la technique sol-gel consistant à préparer l'oxyde par mélange de précurseurs métalliques en solution, suivie d'une étape de dépôt sur un substrat de ladite solution obtenue.

En particulier, lorsque la céramique oxyde à préparer correspond à une céramique oxyde du type PMNT, telle que mentionnée ci-dessus, on peut préparer une solution à partir des précurseurs suivants : l'acétate de plomb trihydraté, l'acétate de magnésium, l'éthoxyde de niobium et l'isopropoxyde de titane. Plus précisément, la préparation de cette solution comprend, dans un premier temps, la mise en contact d'acétate de plomb et d'acétate de magnésium avec du 2-méthoxyéthanol, l'ensemble étant ensuite porté à reflux pendant 1 heure à 100°C. L'eau résiduelle, provenant notamment du précurseur acétate de plomb, est ensuite éliminée par distillation à 125°C. Après refroidissement à température ambiante, l'isopropoxyde de titane et l'éthoxyde de niobium sont ajoutés à la solution sous flux d'argon. La concentration de la solution résultante peut être ajustée soit par addition du solvant (afin de diminuer ladite concentration) soit par distillation d'une partie de celui-ci (afin d'augmenter ladite concentration). On obtient ainsi une solution dite « solution mère » (ou encore appelée « solution stock »).

La solution sol-gel obtenue peut être ensuite déposée par les techniques suivantes :
- le trempage-retrait (connu sous la terminologie anglaise « dip-coating ») ;
- l'enduction centrifuge (connue sous la terminologie anglaise « spin-coating ») ;
- l'enduction laminaire (connue sous la terminologie anglaise « laminar-flow-coating ou meniscus coating ») ;
- la pulvérisation (connue sous la terminologie anglaise « spray-coating ») ;
- l'épandage (connu sous la terminologie anglaise « soak coating ») ;
- l'enduction au rouleau (connue sous la terminologie « roll- to- roll process ») ;
- l'enduction au pinceau (connue sous la terminologie anglaise « paint coating ») ;
- la sérigraphie (connue sous la terminologie anglaise « screen printing »).

Avantageusement, la solution sol-gel est déposée par enduction centrifuge, ce qui permet un contrôle précis de l'épaisseur de couche déposée.

Indépendamment de la manière dont peut se faire l'étape de dépôt, le substrat peut être en tout ou partie conducteur de l'électricité, par exemple en un métal (par exemple, un substrat comprenant du platine ou du ruthénium). Il peut être également en un matériau choisi parmi le silicium éventuellement oxydé, le saphir, un matériau semi-conducteur présentant des interconnexions conductrices de l'électricité, une céramique conductrice de l'électricité ou un diélectrique. Le substrat peut être isolant électriquement.

Une fois l'étape de dépôt effectuée, il est procédé à une étape de recuit de cristallisation de la couche préalablement déposée en la chauffant à une température inférieure ou égale à 550°C, avantageusement à une température allant de 400 à 450°C, à l'issue de laquelle la couche comprend, au moins en partie, une phase cristalline pyrochlore.

A l'issue du procédé, on peut ainsi obtenir un matériau céramique oxyde à base de plomb comprenant au moins une phase cristalline pyrochlore, sous forme d'un film, pouvant présenter une épaisseur allant de 0,01 à 1 µm, par exemple, de 40 à 110 nm et présentant au moins l'une des propriétés électriques suivantes :
- une constante diélectrique relative supérieure ou égale à 40 ;
- un facteur de dissipation diélectrique inférieur ou égal à 0,015.

Du fait que l'étape de recuit de cristallisation est réalisée à une température inférieure ou égale à 550°C, il est possible de mettre en oeuvre ce procédé pour la réalisation de capacités, destinées notamment à entrer dans l'élaboration de circuits intégrés, par exemple CMOS, ces circuits CMOS imposant une température maximale d'élaboration de 550°C, voire de 450°C, afin de préserver l'intégrité des métaux d'interconnexion. Le procédé de l'invention est donc particulièrement avantageux pour l'approche dite « above IC », telle que définie déjà ci-dessus.

Il est possible de mettre en oeuvre ce procédé pour la réalisation de composants de type « Stand alone », qui sont des circuits pour lesquels il n'y a pas de circuits intégrés en dessous. Ainsi, la réalisation des circuits intégrés et des composants passifs se fait sur deux substrats distincts. Il n'y a pas donc pas de limitation thermique due aux circuits intégrés pour la réalisation de composants passifs.

Ainsi, l'invention a trait également à un procédé d'élaboration d'une capacité, en particulier d'une capacité disposée au-dessus d'un circuit intégré, comprenant :
- une étape de mise en oeuvre du procédé tel que défini ci-dessus, le substrat étant conducteur de l'électricité au moins dans sa partie supérieure en contact avec la couche en matériau oxyde, laquelle partie constituant ainsi l'électrode inférieure, la couche en matériau oxyde comprenant au moins une phase cristalline pyrochlore constituant la zone diélectrique ;
- une étape de dépôt d'une couche conductrice de l'électricité, par exemple, en un métal tel que le platine, sur la face de la couche en matériau oxyde opposée à la face en contact avec le substrat, de sorte à constituer l'électrode supérieure.

Dans ce cas de figure, le substrat sera avantageusement, dans sa partie supérieure, en un métal tel que le platine, afin de constituer l'électrode inférieure.

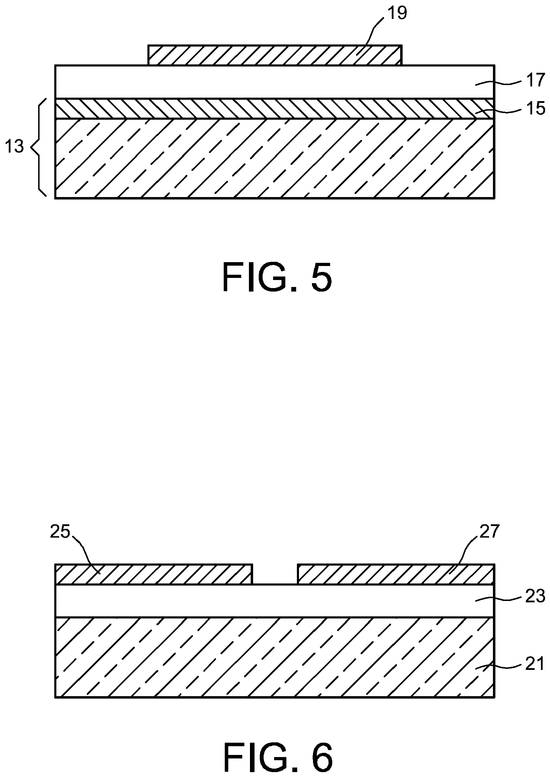

Une telle capacité est représentée sur la figure 5, comprenant :
- un substrat 13, dont la partie supérieure 15 est conductrice de l'électricité, formant ainsi l'électrode inférieure de la capacité ;
- une couche en matériau oxyde de phase pyrochlore 17 obtenue selon le procédé de l'invention ;
- une couche conductrice de l'électricité 19 déposée sur ladite couche en matériau oxyde, formant ainsi l'électrode supérieure de la capacité.

Selon un autre mode de réalisation, l'invention a trait également à un procédé d'élaboration d'une capacité, en particulier d'une capacité disposée au-dessus d'un circuit intégré, comprenant :
- une étape de mise en oeuvre du procédé tel que défini ci-dessus, le substrat étant isolant de l'électricité au moins dans sa partie supérieure en contact avec la couche en matériau oxyde, la couche en matériau oxyde comprenant au moins une phase cristalline pyrochlore constituant la zone diélectrique ;
- une étape de dépôt de deux couches distinctes conductrices de l'électricité, par exemple, en un métal tel que le platine, sur la face de la couche en matériau oxyde opposée à la face en contact avec le substrat, de sorte à former deux électrodes distinctes, qui constitueront lors du fonctionnement de la capacité les deux électrodes de polarité opposée.

Une telle capacité est représentée sur la figure 6, comprenant :
- un substrat 21;
- une couche en matériau oxyde de phase pyrochlore 23 obtenue selon le procédé de l'invention ;
- deux couches distinctes conductrice de l'électricité 25, 27, déposées sur ladite couche en matériau oxyde, formant ainsi deux électrodes distinctes.

Les capacités obtenues sont des capacités du type métal-isolant-métal et pouvant être utilisées à basse fréquence ou en radiofréquence.

Dans le cadre de l'élaboration d'une capacité, le substrat conducteur de l'électricité défini ci-dessus peut être préalablement déposé sur un empilement de couches comprenant successivement une couche de silicium, une couche de silice SiO₂ et une couche de titane ou de dioxyde de titane, cette couche servant de couche d'accrochage du substrat conducteur de l'électricité sur la silice. La couche de silice, quant à elle, constitue une barrière de diffusion classique entre les couches sus-jacentes et le silicium.

L'invention va maintenant être décrite plus en détail par rapport aux exemples suivants donnés ci-dessous à titre illustratif et non limitatif.

### BRÈVE DESCRIPTION DES DESSINS

La figure 1 représente une vue en coupe d'une capacité réalisée conformément au procédé de l'invention.
La figure 2 est un diagramme de diffraction aux rayons X (Intensité I (en unités atomique u.a) en fonction de l'angle 2θ (°)) d'une couche en matériau oxyde céramique de composition nominale 0,9Pb(Mg_{1/3}Nb_{2/3})O₃-0,1PbTiO₃ obtenue conformément au protocole décrit dans l'exemple ci-dessous (courbes a, b, c et d, pour des températures respectives de recuit de 400, 450, 500 et 550°C).

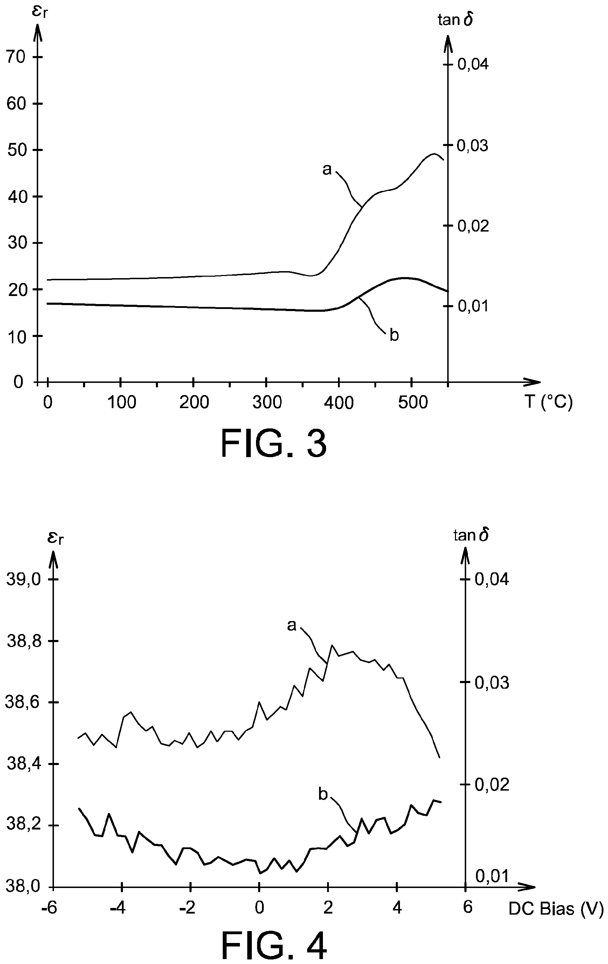

La figure 3 est un graphique illustrant l'évolution de la constante diélectrique relative εᵣ et du facteur de dissipation diélectrique tanδ pour une couche en matériau oxyde céramique de composition nominale 0,9Pb(Mg_{1/3}Nb_{2/3})O₃-0,1PbTiO₃ obtenue conformément au protocole décrit dans l'exemple ci-dessous à différentes températures de recuit T (°C) (température ambiante, 300, 350, 400, 450, 500 et 550°C).
La figure 4 est un graphique illustrant l'évolution de la constante diélectrique εᵣ et du facteur de dissipation électrique tanδ pour une couche en matériau oxyde céramique de composition nominale 0,9Pb(Mg_{1/3}Nb_{2/3})O₃ -0,1PbTiO₃ recuite à une température de 450°C obtenue conformément au protocole décrit dans l'exemple ci-dessous en fonction de la tension de polarisation à courant continu DC Bias (en V) (allant de -6V à +6V).
Les figures 5 et 6 représentent une vue en coupe d'une capacité réalisée conformément au procédé de l'invention selon deux modes de réalisation.

### EXPOSÉ DÉTAILLÉ DE MODES DE RÉALISATION PARTICULIERS

### EXEMPLE

Sur un empilement de couches comprenant, comme illustré sur la figure 1 :
- une plaque de silicium 1 ;
- une couche de silice SiO₂ 3 d'épaisseur d'environ 0,5 µm ;
- une couche de dioxyde de titane TiO₂ 5 d'épaisseur d'environ 20 nm ;
- une couche de platine Pt 7 d'épaisseur d'environ 100 nm.

Il est procédé au dépôt d'une couche amorphe de céramique oxyde de composition nominale 0,9Pb(Mg_{1/3}Nb_{2/3})O₃ -0,1PbTiO₃ 9 (la cible de pulvérisation ayant été achetée auprès du fournisseur Super Conductor Materials, Inc., USA) avec 15% de MgO en excès par pulvérisation magnétron avec de l'argon en tant que gaz plasmagène.

L'empilement résultant est ensuite soumis à différentes températures de recuit, s'échelonnant de la température ambiante, 300, 350, 400, 450°C, 500 et 550°C dans un four conventionnel à l'air.

La couche de céramique oxyde présente une épaisseur d'environ 50 nm.

Pour procéder à l'estimation des propriétés électriques et diélectriques de la couche en céramique oxyde déposée, on dépose à la surface de ladite couche des électrodes en platine de forme circulaire 11 de 110 µm de diamètre par une méthode alliant à la fois la pulvérisation en courant continu et la lithographie.

Les propriétés diélectriques et électriques sont réalisées à température ambiante en utilisant un analyseur du type Agilent B1500A et un analyseur à impédance HP 4194.

La figure 2 représente un diagramme de diffraction aux rayons X de la couche en céramique oxyde obtenue à des températures de recuit de cristallisation respectivement de 400, 450, 500 et 550°C (courbes a, b, c et d), ces courbes attestant de la présence d'une phase pyrochlore pour de telles températures de recuit (pics P1 et P2 sur la figure 2), la proportion de phase pyrochlore étant plus importante pour une température de recuit de 450°C.

Il est procédé ensuite à la mesure, à une fréquence de 10 kHz, de la constante diélectrique relative εᵣ (courbe a) et du facteur de dissipation thermique tanδ (courbe b) d'une couche en céramique oxyde telle que préparée ci-dessus pour différentes températures de recuit (respectivement température ambiante, 300°C, 350°C 400°C, 450°C, 500 et 550°C). Les valeurs de mesure sont reportées sur la figure 3.

De cette figure, on peut constater qu'à partir de 400°C, on observe une augmentation significative de la constante diélectrique relative (courbe a).

Il a été également procédé à la mesure de la constante diélectrique et du facteur de dissipation électrique pour une couche de céramique oxyde recuite à une température de 450°C conformément à ce qui est décrit ci-dessus en fonction de la tension de polarisation à courant continu. Les valeurs de ces mesures sont reportées sur la figure 4.

On peut constater une augmentation de la constante diélectrique relative sur une grande partie des valeurs de tension de polarisation (courbe a) attestant d'une variation de la capacitance négative en fonction de la tension de polarisation à courant continu.

Quant au facteur de dissipation électrique, il reste à des valeurs inférieures à 0,02 sur toute la gamme de tension de polarisation (courbe b).

## Revendications

1. Procédé de préparation d'un matériau diélectrique céramique oxyde à base de plomb comprenant au moins une phase cristalline pyrochlore choisi parmi le niobate de plomb, le magnoniobate de plomb et une solution solide résultant d'un mélange de magnoniobate de plomb et de titanate de plomb comprenant les étapes suivantes :
a) une étape de dépôt sur un substrat d'au moins une couche amorphe dudit matériau céramique oxyde à base de plomb ;
b) une étape de recuit de cristallisation de ladite couche amorphe à une température inférieure ou égale à 550°C, moyennant quoi l'on obtient ledit matériau diélectrique céramique oxyde à base de plomb comprenant au moins une phase pyrochlore choisi parmi le niobate de plomb, le magnoniobate de plomb et une solution solide résultant d'un mélange de magnoniobate de plomb et de titanate de plomb.

2. Procédé selon la revendication 1, dans lequel le matériau diélectrique céramique oxyde à base de plomb est une solution solide résultant d'un mélange de magnoniobate de plomb et de titanate de plomb pouvant répondre à la composition nominale suivante:
(1-x)Pb(Mg_{1/3}Nb_{2/3})O₃-xPbTiO₃
x allant de 0 à 1, 1 n'étant pas inclus.

3. Procédé selon l'une quelconque des revendications précédentes, dans lequel l'étape de dépôt a) est réalisée par une étape de dépôt physique en phase vapeur (connue sous l'abréviation PVD), une technique de dépôt chimique en phase vapeur (connue sous l'abréviation CVD) ou une technique de dépôt par voie sol-gel.

4. Procédé selon la revendication 3, dans lequel la technique de dépôt physique en phase vapeur est une technique de dépôt par évaporation sous vide ou par pulvérisation cathodique.

5. Procédé selon l'une quelconque des revendications précédentes, dans lequel l'étape de dépôt a) est réalisée par pulvérisation cathodique magnétron.

6. Procédé selon l'une quelconque des revendications précédentes, dans lequel le substrat est en tout ou partie conducteur de l'électricité.

7. Procédé selon la revendication 6, dans lequel le substrat comprend du platine ou du ruthénium.

8. Procédé selon l'une quelconque des revendications précédentes, dans lequel l'étape de recuit de cristallisation b) est réalisée à une température inférieure ou égale à 450°C.

9. Procédé selon l'une quelconque des revendications précédentes, dans lequel l'étape de recuit de cristallisation b) est réalisée à une température allant de 400 à 450°C.

10. Procédé selon l'une quelconque des revendications précédentes, dans lequel l'étape a) et l'étape b) sont mises en oeuvre successivement ou simultanément.

11. Procédé selon l'une quelconque des revendications précédentes, dans lequel le matériau diélectrique céramique oxyde à base de plomb comprenant au moins une phase cristalline pyrochlore se présente sous forme d'un film présentant une épaisseur allant de 0,01 à 1 µm.

12. Procédé selon l'une quelconque des revendications précédentes, dans lequel le matériau diélectrique céramique oxyde à base de plomb comprenant au moins une phase cristalline pyrochlore présente au moins l'une des propriétés électriques suivantes :
- une constante diélectrique relative supérieure ou égale à 40 ;
- un facteur de dissipation diélectrique inférieur ou égal à 0,015.

13. Procédé d'élaboration d'une capacité, en particulier d'une capacité disposée au-dessus d'un circuit intégré, comprenant :
- une étape de mise en oeuvre du procédé tel que défini selon l'une quelconque des revendications 1 à 12, le substrat étant conducteur de l'électricité au moins dans sa partie supérieure en contact avec la couche en matériau oxyde comprenant au moins une phase cristalline pyrochlore, laquelle partie constitue ainsi l'électrode inférieure, la couche en matériau oxyde comprenant au moins une phase cristalline pyrochlore constituant la zone diélectrique ;
- une étape de dépôt d'une couche conductrice de l'électricité sur la face de la couche en matériau oxyde opposée à la face en contact avec le substrat, de sorte à constituer l'électrode supérieure.

14. Procédé d'élaboration d'une capacité, en particulier d'une capacité disposée au-dessus d'un circuit intégré, comprenant :
- une étape de mise en oeuvre du procédé tel que défini selon l'une quelconque des revendications 1 à 13, le substrat étant isolant de l'électricité au moins dans sa partie supérieure en contact avec la couche en matériau oxyde, la couche en matériau oxyde comprenant au moins une phase cristalline pyrochlore constituant la zone diélectrique ;
- une étape de dépôt de deux couches distinctes conductrices de l'électricité sur la face de la couche en matériau oxyde opposée à la face en contact avec le substrat, de sorte à former deux électrodes distinctes.

## Patentansprüche

1. Verfahren zur Herstellung eines dielektrischen keramischen Oxidmaterials auf Basis von Blei, umfassend wenigstens eine kristalline Pyrochlorphase, die ausgewählt ist aus Bleiniobat, Bleimagnesiumniobat und einer festen Lösung, die aus einer Mischung von Bleimagnesiumniobat und Bleititanat resultiert, umfassend die folgenden Schritte:
a) einen Schritt der Aufbringung wenigstes einer amorphen Schicht des keramischen Oxidmaterials auf Basis von Blei auf einem Substrat;
b) einen Schritt des Kristallisationsheizens der amorphen Schicht bei einer Temperatur von kleiner oder gleich 550°C, wodurch man das dielektrische keramische Oxidmaterial auf Basis von Blei erhält, das wenigstens eine Pyrochlorphase umfasst, ausgewählt aus Bleiniobat, Bleimagnesiumniobat und einer festen Lösung, die aus einer Mischung von Bleimagnesiumniobat und Bleititanat resultiert.

2. Verfahren nach Anspruch 1, wobei das dielektrische keramische Oxidmaterial auf Basis von Blei eine feste Lösung ist, die aus einer Mischung von Bleimagnesiumniobat und Bleititanat resultiert, die der folgenden nominalen Zusammensetzung entsprechen kann:
(1-x)Pb(Mg_{1/3}Nb_{2/3})O₃-xPbTiO₃
wobei x von 0 bis 1 geht, wobei 1 nicht enthalten ist.

3. Verfahren nach einem der vorhergehenden Ansprüche, wobei der Aufbringungsschritt a) realisiert ist durch einen Schritt der physikalischen Dampfphasenaufbringung (bekannt unter der Abkürzung PVD), eine Technik zur chemischen Dampfphasenaufbringung (bekannt unter der Abkürzung CVD), oder eine Technik zur Aufbringung mittels Sol-Gel.

4. Verfahren nach Anspruch 3, wobei die Technik zur physikalischen Dampfphasenaufbringung eine Technik zur Aufbringung durch Verdampfung unter Vakuum oder durch kathodische Pulverisierung ist.

5. Verfahren nach einem der vorhergehenden Ansprüche, wobei der Aufbringungsschritt a) durch kathodische Magnetronpulverisierung realisiert ist.

6. Verfahren nach einem der vorhergehenden Ansprüche, wobei das Substrat vollständig oder teilweise elektrisch leitend ist.

7. Verfahren nach Anspruch 6, wobei das Substrat Platin oder Ruthenium enthält.

8. Verfahren nach einem der vorhergehenden Ansprüche, wobei der Schritt des Kristallisationsheizens b) bei einer Temperatur von kleiner oder gleich 450°C realisiert wird.

9. Verfahren nach einem der vorhergehenden Ansprüche, wobei der Schritt des Kristallisationsheizens b) bei einer Temperatur realisiert wird, die von 400 bis 450°C geht.

10. Verfahren nach einem der vorhergehenden Ansprüche, wobei der Schritt a) und der Schritt b) nacheinander oder gleichzeitig durchgeführt werden.

11. Verfahren nach einem der vorhergehenden Ansprüche, wobei das dielektrische keramische Oxidmaterial auf Basis von Blei, das wenigstens eine kristalline Pyrochlorphase umfasst, die Form eines Films aufweist, der eine Dicke aufweist, welche von 0,01 bis 1 µm geht.

12. Verfahren nach einem der vorhergehenden Ansprüche, wobei das dielektrische keramische Oxidmaterial auf Basis von Blei, das wenigstens eine kristalline Pyrochlorphase umfasst, wenigstens eine der folgenden elektrischen Eigenschaften aufweist:
- eine relative Dielektrizitätskonstante größer oder gleich 40;
- einen dielektrischen Verlustfaktor kleiner oder gleich 0,015.

13. Verfahren zur Ausarbeitung einer Kapazität, insbesondere einer Kapazität, die über einer integrierten Schaltung angeordnet ist, umfassend:
- einen Schritt der Durchführung des Verfahrens wie in einem der Ansprüche 1 bis 12 definiert, wobei das Substrat wenigstens in seinem oberen Teil elektrisch leitend ist, der in Kontakt ist mit der Schicht aus Oxidmaterial, umfassend wenigstens eine kristalline Pyrochlorphase, welcher Teil somit die untere Elektrode bildet, wobei die Schicht aus Oxidmaterial wenigstens eine kristalline Pyrochlorphase umfasst, die die dielektrische Zone bildet;
- einen Schritt der Aufbringung einer elektrisch leitenden Schicht auf die Fläche der Schicht aus Oxidmaterial entgegengesetzt zur Fläche in Kontakt mit dem Substrat, derart, dass die obere Elektrode gebildet wird.

14. Verfahren zur Ausarbeitung einer Kapazität, insbesondere einer Kapazität, die über einer integrierten Schaltung angeordnet ist, umfassend:
- einen Schritt der Durchführung des Verfahrens wie in einem der Ansprüche 1 bis 13 definiert, wobei das Substrat wenigstens in seinem oberen Bereich elektrisch isolierend ist, der in Kontakt ist mit der Schicht aus Oxidmaterial, wobei die Schicht aus Oxidmaterial wenigstens eine kristalline Pyrochlorphase umfasst, die die dielektrische Zone bildet;
- einen Schritt der Aufbringung von zwei verschiedenen elektrisch leitenden Schichten auf die Fläche der Schicht aus Oxidmaterial entgegengesetzt zur Fläche in Kontakt mit dem Substrat, derart, dass zwei verschiedene Elektroden gebildet werden.

## Claims

1. Process for forming a lead-based ceramic oxide dielectric material comprising at least one pyrochlore crystalline phase chosen from lead niobate; lead magnesium niobate; and a solid solution resulting from a mixture of lead magnesium niobate and lead titanate, which process comprises the following steps:
a) a step of depositing at least one amorphous layer of said lead-based ceramic oxide material on a substrate; and
b) a crystallization annealing step carried out on said amorphous layer at a temperature not exceeding 550°C, by means of which a lead-based ceramic oxide dielectric material comprising at least one pyrochlore phase chosen from lead niobate; lead magnesium niobate; and a solid solution resulting from a mixture of lead magnesium niobate and lead titanate is obtained.

2. Process according to Claim 1, in which the lead-based ceramic oxide dielectric material is a solid solution resulting from a mixture of lead magnesium niobate and lead titanate, which may satisfy the following nominal composition:
(1-x)Pb(Mg_{1/3}Nb_{2/3})O₃-xPbTiO₃
x ranging from 0 to 1, 1 not being inclusive.

3. Process according to any one of the preceding claims, in which deposition step a) is carried out by a physical vapour deposition (PVD) step, a chemical vapour deposition (CVD) technique or a sol-gel deposition technique.

4. Process according to Claim 3, in which the physical vapour deposition technique is a vacuum evaporation deposition or sputtering technique.

5. Process according to any one of the preceding claims, in which deposition step a) is carried out by magnetron sputtering.

6. Process according to any one of the preceding claims, in which all or part of the substrate is electrically conductive.

7. Process according to Claim 6, in which the substrate comprises platinum or ruthenium.

8. Process according to any one of the preceding claims, in which crystallisation annealing step b) is carried out at a temperature not exceeding 450°C.

9. Process according to any one of the preceding claims, in which crystallisation annealing step b) is carried out at a temperature ranging from 400 to 450°C.

10. Process according to any one of the preceding claims, in which step a) and step b) are carried out in succession or simultaneously.

11. Process according to any one of the preceding claims, in which the lead-based ceramic oxide dielectric material comprising at least one pyrochlore crystalline phase takes the form of a film having a thickness ranging from 0.01 to 1 µm.

12. Process according to any one of the preceding claims, in which the lead-based ceramic oxide dielectric material comprising at least one pyrochlore crystalline phase has at least one of the following electrical properties:
- a relative dielectric constant of 40 or higher; and
- a dielectric dissipation factor of 0.015 or lower.

13. Process for forming a capacitor, in particular a capacitor placed on an integrated circuit, comprising:
- a step of implementing the process as defined in any one of Claims 1 to 12, the substrate being electrically conductive at least in its upper part in contact with the layer of oxide material comprising at least one pyrochlore crystalline phase, which part thus constitutes the lower electrode, the layer of oxide material comprising at least one pyrochlore crystalline phase constituting the dielectric region; and
- a step of depositing an electrically conductive layer on the face of the layer of oxide material on the opposite side from the face in contact with the substrate, so as to constitute the upper electrode.

14. Process for forming a capacitor, in particular a capacitor placed above an integrated circuit, comprising:
- a step of implementing the process as defined in any one of Claims 1 to 13, the substrate being electrically insulating at least in its upper part in contact with the layer of oxide material, the layer of oxide material comprising at least one pyrochlore crystalline phase constituting the dielectric region; and
- a step of depositing two separate electrically conductive layers on the face of the layer of oxide material on the opposite side from the face in contact with the substrate, so as to form two separate electrodes.
